(19) Europäisches Patentamt / European Patent Office / Office européen des brevets

(11) EP 4 733 350 A1

(12) **EUROPEAN PATENT APPLICATION**

(43) Date of publication:
**29.04.2026 Bulletin 2026/18**

(21) Application number: **25209349.7**

(22) Date of filing: **17.10.2025**

(51) International Patent Classification (IPC):
***C08K 3/00*** *(2018.01)* ***C08G 59/00*** *(2006.01)*
***C08K 5/54*** *(2006.01)*

(52) Cooperative Patent Classification (CPC):
(C-Sets available)
**C08L 63/00; C08L 63/04** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **21.10.2024 JP 2024185213**

(71) Applicant: **SHIN-ETSU CHEMICAL CO., LTD.**
**Tokyo 1000005 (JP)**

(72) Inventors:
- **HORIGOME, Hiroki**
  **Gunma, 379-0224 (JP)**
- **OSADA, Shoichi**
  **Gunma, 379-0224 (JP)**
- **KAWAMURA, Norifumi**
  **Gunma, 379-0224 (JP)**
- **MOCHIZUKI, Takanari**
  **Gunma, 379-0224 (JP)**
- **HAGIWARA, Kenji**
  **Gunma, 379-0224 (JP)**
- **YOKOTA, Ryuhei**
  **Gunma, 379-0224 (JP)**

(74) Representative: **Ipsilon**
**12, Avenue d'Italie**
**75013 Paris (FR)**

(54) **THERMOSETTING RESIN COMPOSITION AND A SEMICONDUCTOR DEVICE**

(57) One of the purposes of the present invention is to provide a thermosetting resin composition with excellent adhesion to metals. A thermosetting resin composition, comprising the following components (A) to (D):
(A) a thermosetting resin;
(B) a silane coupling agent represented by the following formula (I):

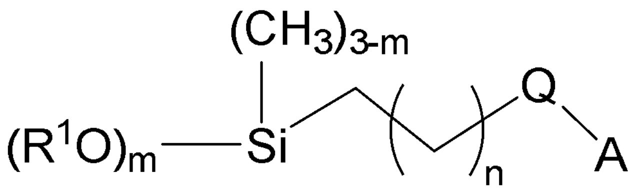
(I)

wherein, in formula (I), $R^1$ is, independently of each other, an alkyl group having 1 to 8 carbon atoms, m is an integer of 1 to 3, n is an integer of 0 to 10, Q is a single bond or an amide bond (-NHCO-), A is a nitrogen-containing heterocyclic group having at least two nitrogen atoms, wherein one of the nitrogen atoms is bonded to the carbon atom of $-(CH_2)_n-$ or of -NHCO-;
(C) a curing accelerator; and
(D) an inorganic filler.

EP 4 733 350 A1

(52) Cooperative Patent Classification (CPC): (Cont.)

C-Sets
**C08L 63/00, C08L 61/06, C08K 3/36,**
**C08K 5/5477;**
**C08L 63/04, C08L 61/06, C08K 3/36, C08K 5/5477**

## Description

## BACKGROUND

One aspect of the present invention relates to a thermosetting resin composition and a semiconductor device that includes a cured product of the thermosetting resin composition.

As electronic devices have become smaller and lighter in recent years, the need has grown for high-density mounting of electronic components on circuit boards. Compared to conventional pin insertion-type packages, surface mounted packages can be mounted without using much board area, enabling smaller and lighter electronic devices.

A surface mounted package passes through a reflow furnace when being soldered to a board, which exposes the entire package to high temperatures. If the package has absorbed moisture, the moisture abruptly expands to cause delamination between the element, leadframe, or other inserts and the encapsulant, resulting in package cracks. It is therefore desirable for the encapsulant to produce good adhesion to the insert after moisture absorption and reflow.

According to Patent Literature 1, epoxy group-containing silane coupling agents, amino group-containing silane coupling agents, and thiol group-containing silane coupling agents were considered, but produced insufficient adhesion to nickel and nickel/palladium/gold.

## PRIOR LITERATURE

## PATENT LITERATURE

Patent Literature 1: Japanese Patent Application Laid-Open No. 2007-063549

## SUMMARY

Therefore, one of the purposes of the present invention is to provide a thermosetting resin composition with excellent adhesion to metals.

As a result of repeating diligent research to solve the aforementioned problem, the present inventors found that thermosetting resin compositions containing specific silane coupling agents, which will be described below, accomplish the aforementioned purpose, thereby completing the present invention. In other words, the present invention provides the following thermosetting resin compositions and semiconductor devices that include cured products of the compositions.

That is, one aspect of the present invention provides a thermosetting resin composition defined in the following item [1], comprising the following components (A) to (D).

[1] A thermosetting resin composition, comprising the following components (A) to (D):

(A) a thermosetting resin;

(B) a silane coupling agent represented by the following formula (I):

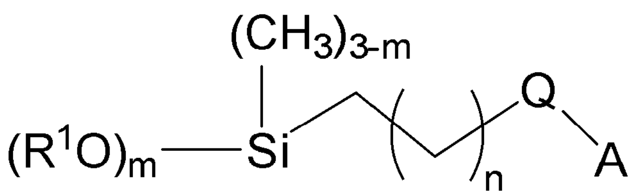

(I)

wherein, in formula (I), $R^1$ is, independently of each other, an alkyl group having 1 to 8 carbon atoms, m is an integer of 1 to 3, n is an integer of 0 to 10, Q is a single bond or an amide bond, -NHCO-, "A" is a nitrogen-containing heterocyclic group having at least two nitrogen atoms, wherein one of the nitrogen atoms is bonded to the carbon atom of $-(CH_2)_n-$ or of -NHCO-;

(C) a curing accelerator; and

(D) an inorganic filler.

The present invention further provides thermosetting resin compositions having at least one configuration according to the following items [2] to [9].

[2] The thermosetting resin composition according to item [1], wherein the silane coupling agent (B) is one or more selected from compounds represented by the following formulas (1) to (4):

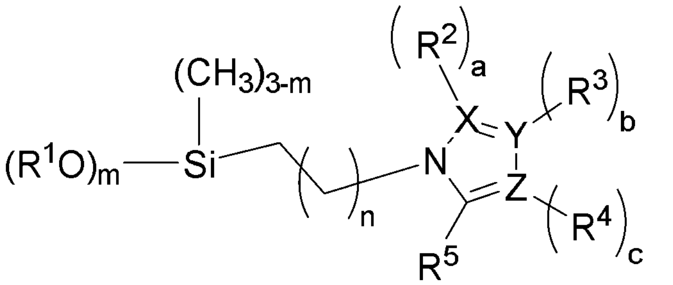

(1)

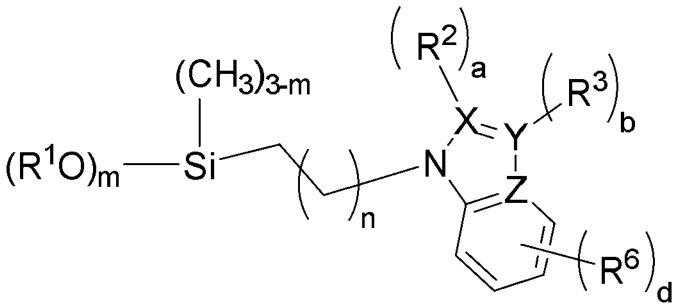

(2)

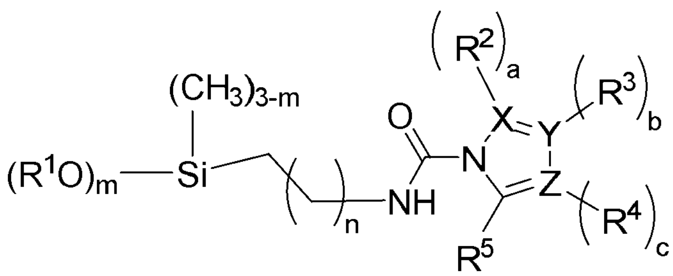

(3)

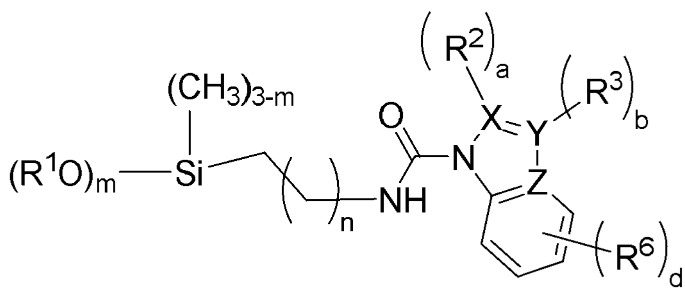

(4)

wherein, in formulas (1) to (4), $R^1$ is, independently of each other, an alkyl group having 1 to 8 carbon atoms, X, Y, and Z are, independently of each other, a carbon atom or a nitrogen atom, one or two among X, Y, and Z are a nitrogen atom, $R^2$ to $R^6$ are, independently of each other, a hydrogen atom, an alkyl group having 1 to 8 carbon atoms, or a phenyl group, m is an integer of 1 to 3, n is an integer of 0 to 10, a, b, and c are 0 or 1, wherein a is 1 when X is a carbon atom, a is 0 when X is a nitrogen atom, b is 1 when Y is a carbon atom, b is 0 when Y is a nitrogen atom, c is 1 when Z is a carbon atom, c is 0 when Z is a nitrogen atom, and d is an integer of 0 to 4.

[3] The thermosetting resin composition according to item [1] or [2] or both, wherein the thermosetting resin composition optionally comprises an curing agent, and an amount of component (B) is 0.1 to 10 parts by mass, an amount of component (C) is 0.2 to 8 parts by mass, and an amount of component (D) is 50 to 1,500 parts by mass, relative to total 100 parts by mass of component (A) and the optional curing agent.

[4] The thermosetting resin composition according to at least one of items [1] to [3] or all, wherein an amount of component (D) is 30 to 97% by mass, relative to a total mass of the thermosetting resin composition.

[5] The thermosetting resin composition according to at least one of items [1] to [4] or all, wherein the thermosetting resin (A) is one or more selected from the group consisting of an epoxy resin, a phenolic resin, a maleimide resin, a bismaleimide resin, a citraconimide resin, a cyclic imide compound, a cyanate ester compound, a styrene resin, a cyclopentadiene compound and oligomers thereof, an oxetane resin, a (meth)acrylate resin, a terminal (meth)acrylic

group-modified polyphenylene ether resin, an unsaturated polyester resin, and a diallyl phthalate resin.

[6] The thermosetting resin composition according to at least one of items [1] to [5] or all, wherein the thermosetting resin (A) is an epoxy resin.

[7] The thermosetting resin composition according to item [6], further comprising a curing agent.

[8] The thermosetting resin composition according to item [6] or [7] or both, wherein the epoxy resin is one or more selected from the group consisting of a phenol novolac-type epoxy resin, an orthocresol novolac-type epoxy resin, a biphenyl-type epoxy resin, a bisphenol-type epoxy resin, a triphenolmethane-type epoxy resin, an alkyl-modified triphenolmethane-type epoxy resin, a phenol aralkyl-type epoxy resin, a biphenyl aralkyl-type epoxy resin, and a dicyclopentadiene-modified phenol-type epoxy resin.

[9] The thermosetting resin composition according to at least one of items [6] to [8] or all, wherein the curing agent is one or more selected from the group consisting of a phenol novolac resin, an orthocresol novolac resin, a triphenolmethane resin, an alkyl-modified triphenolmethane resin, a phenol aralkyl resin, a biphenyl aralkyl resin, and a dicyclopentadiene-modified phenolic resin.

[10] The thermosetting resin composition according to at least one of items [1] to [9] or all, wherein Q in formula (I) is a single bond.

The present invention further provides a semiconductor device that includes a cured product of the aforementioned thermosetting resin composition.

The thermosetting resin composition of the present invention has excellent adhesion to metals, even after moisture absorption and reflow. Accordingly, the thermosetting resin composition of the present invention is useful as an encapsulant of surface mounted packages.

## DETAILED DESCRIPTION

The present invention will be explained below in more detail.

(A) Thermosetting resin

The thermosetting resin composition of the present invention contains a thermosetting resin (A). The thermosetting resin may be, for example, a resin including one or more selected from an epoxy resin, a phenolic resin, a maleimide resin, a bismaleimide resin, a citraconimide resin, a cyclic imide compound, a cyanate ester compound, a styrene resin, a cyclopentadiene compound and oligomers thereof, an oxetane resin, a (meth)acrylate resin, a terminal (meth)acrylic group-modified polyphenylene ether resin, an unsaturated polyester resin, a diallyl phthalate resin, and other resins. Preferred among them is an epoxy resin. The blending ratio of the thermosetting resin (A) in the thermosetting resin composition of the present invention is such that the amount of the thermosetting resin is 3 to 60% by mass, preferably 5 to 50% by mass, relative to the total mass of the composition.

The epoxy resin is not particularly limited, and includes epoxy resins conventionally used in the technical field of epoxy resin compositions for semiconductor encapsulation. Examples of such an epoxy resin include crystalline epoxy resins such as a phenol novolac-type epoxy resin, an orthocresol novolac-type epoxy resin, a naphthol novolac-type epoxy resin, a biphenyl-type epoxy resin, a bisphenol-type epoxy resin, a stilbene-type epoxy resin, and a dihydroanthracenediol-type epoxy resin; polyfunctional epoxy resins such as a triphenolmethane-type epoxy resin and an alkyl-modified triphenolmethane-type epoxy resin; aralkyl-type epoxy resins such as a phenol aralkyl-type epoxy resin having a phenylene skeleton, a biphenyl aralkyl-type epoxy resin having a biphenylene skeleton, a naphthol aralkyl-type epoxy resin having a phenylene skeleton, and a naphthol biphenyl aralkyl-type epoxy resin having a biphenylene skeleton; naphthol-type epoxy resins such as a dihydroxynaphthalene-type epoxy resin and an epoxy resin formed by glycidyl etherification of a dimer of dihydroxynaphthalene; triazine structure-containing epoxy resins such as triglycidyl isocyanurate and monoallyl diglycidyl isocyanurate; and cyclic hydrocarbon compound-modified phenol-type epoxy resins such as a dicyclopentadiene-modified phenol-type epoxy resin. These may be used alone or in combination with two or more thereof. Preferred among them are a phenol novolac-type epoxy resin, an orthocresol novolac-type epoxy resin, a biphenyl-type epoxy resin, a bisphenol-type epoxy resin, a triphenolmethane-type epoxy resin, an alkyl-modified triphenolmethane-type epoxy resin, a phenol aralkyl-type epoxy resin, a biphenyl aralkyl-type epoxy resin, and a dicyclopentadiene-modified phenol-type epoxy resin, in view of their excellent moldability and curability.

The epoxy resin may be used with a curing agent. A phenolic resin, an acid anhydride, an amine, an active ester, and the like may be used as the curing agent. Preferred among them is a phenolic resin, in view of its heat resistance and moisture resistance.

Examples of the phenolic resin include a phenol novolac resin, an orthocresol novolac resin, a triphenolmethane resin, an alkyl-modified triphenolmethane resin, a phenol aralkyl resin, a biphenyl aralkyl resin, a dicyclopentadiene-modified phenolic resin, a naphthalene ring-containing phenolic resin, a biphenyl-type phenolic resin, an alicyclic phenolic resin, a heterocyclic phenolic resin, a naphthalene ring-containing phenolic resin, a bisphenol A phenolic resin, and a

bisphenol F phenolic resin. These may be used alone or in combination with two or more thereof. Preferred among them are a phenol novolac resin, an orthocresol novolac resin, a triphenolmethane resin, an alkyl-modified triphenolmethane resin, a phenol aralkyl resin, a biphenyl aralkyl resin, and a dicyclopentadiene-modified phenolic resin, in view of their excellent moldability and curability.

The blending ratio of the epoxy resin to the curing agent may be appropriately adjusted according to conventionally-known blending ratios. When, for example, the curing agent is a phenolic resin, the amounts of the epoxy resin and the curing agent are such that the equivalent ratio of epoxy group/phenolic hydroxy group is 0.5 or more and 1.5 or less, more preferably 0.8 or more and 1.2 or less. If the blending ratio is within these ranges, the curing agent amount is appropriate and does not result in undercure.

(B) Silane coupling agent

The thermosetting resin composition of the present invention contains a silane coupling agent (B) having a nitrogen-containing heterocyclic group. The silane coupling agent produces adhesion by coordinating with an adherend metal. The silane coupling agent may be represented by the following formula (I):

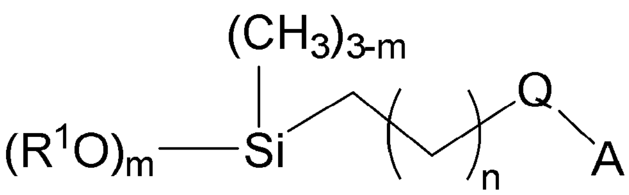

(I)

wherein $R^1$ is, independently of each other, an alkyl group having 1 to 8 carbon atoms, m is an integer of 1 to 3, n is an integer of 0 to 10, Q is a single bond or an amide bond (-NHCO-), and A is a nitrogen-containing heterocyclic group having at least two nitrogen atoms, wherein one of the nitrogen atoms is bonded to the carbon atom of $-(CH_2)_n-$ or of -NHCO-. "A" is preferably a heterocyclic group having a five-membered ring having at least two nitrogen atoms. Such a heterocyclic group is preferably a group having one structure selected from the group consisting of an imidazole structure, a pyrazole structure, a 1,2,3-triazole structure, a 1,2,4-triazole structure, a benzimidazole structure, a benzopyrazole structure, and a 1,2,3-benzotriazole structure. "Q" is preferably a single bond.

Component (B) is more preferably one or more silane coupling agents selected from compounds represented by the following formulas (1) to (4). The silane coupling agent may be used alone or in combination with two or more thereof.

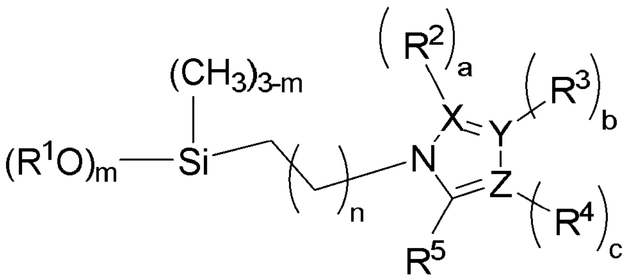

(1)

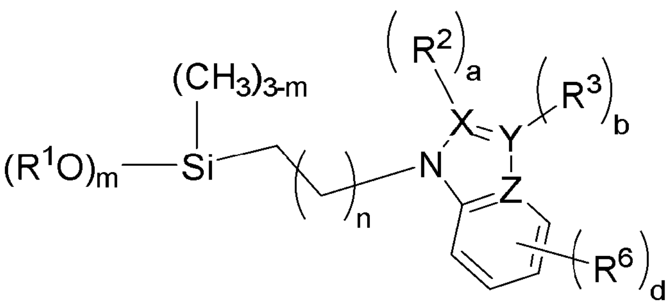

(2)

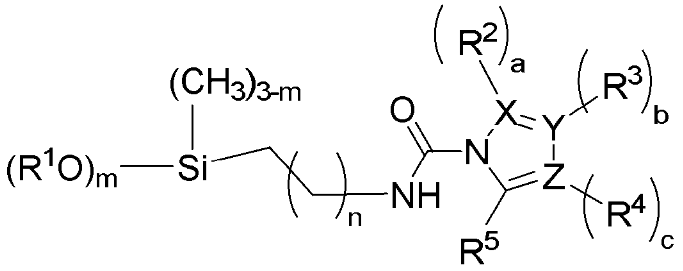

(3)

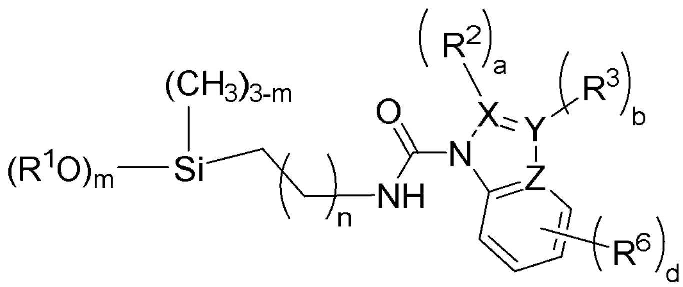

(4)

In formulas (1) to (4), $R^1$ is, independently of each other, an alkyl group having 1 to 8 carbon atoms, X, Y, and Z are, independently of each other, a carbon atom or a nitrogen atom, wherein one or two among X, Y, and Z are a nitrogen atom, $R^2$ to $R^6$ are, independently of each other, a hydrogen atom, an alkyl group having 1 to 8 carbon atoms, or a phenyl group, m is an integer of 1 to 3, n is an integer of 0 to 10, a, b, and c are 0 or 1, wherein a is 1 when X is a carbon atom, a is 0 when X is a nitrogen atom, b is 1 when Y is a carbon atom, b is 0 when Y is a nitrogen atom, c is 1 when Z is a carbon atom, c is 0 when Z is a nitrogen atom, and d is an integer of 0 to 4.

In formulas (1) to (4), the alkyl group having 1 to 8 carbon atoms represented by $R^1$ may be any of linear, branched, and cyclic. Examples of such an alkyl group include methyl, ethyl, n-propyl, isopropyl, n-butyl, isobutyl, *tert*-butyl, n-pentyl, neopentyl, n-hexyl, cyclohexyl, n-heptyl, and n-octyl groups. Among them, an alkyl group having 1 to 3 carbon atoms is preferred, and a methyl group and an ethyl group are more preferred.

In formulas (1) to (4), $R^2$ to $R^6$ are, independently of each other, a hydrogen atom, an alkyl group having 1 to 8 carbon atoms, or a phenyl group. Examples of the alkyl group having 1 to 8 carbon atoms include methyl, ethyl, n-propyl, isopropyl, n-butyl, isobutyl, *tert*-butyl, n-pentyl, neopentyl, n-hexyl, cyclohexyl, n-heptyl, and n-octyl groups. Preferred among them is an alkyl group having 1 to 3 carbon atoms. More preferably, $R^2$ to $R^6$ are a hydrogen atom, and even more preferably all of $R^2$ to $R^6$ are a hydrogen atom.

In formulas (1) to (4), m is an integer of 1 to 3, preferably 3. "n" is an integer of 0 to 10, preferably 2 to 7. "d" is an integer of 0 to 4, preferably 0.

X, Y, and Z are, independently of each other, a carbon atom or a nitrogen atom. At least one among X, Y, and Z is a nitrogen atom, and more preferably one or two among X, Y, and Z are a nitrogen atom. In formulas (1) to (4), a is 1 when X is a carbon atom, and a is 0 when X is a nitrogen atom. b is 1 when Y is a carbon atom, and b is 0 when Y is a nitrogen atom. c is 1 when Z is a carbon atom, and c is 0 when Z is a nitrogen atom.

Component (B) is not particularly limited as long as the aforementioned structure is satisfied. The nitrogen-containing heterocyclic group represented by A in formula (I) preferably has imidazole, pyrazole, 1,2,3-triazole, 1,2,4-triazole, benzimidazole, benzopyrazole, and 1,2,3-benzotriazole structures.

Component (B) is particularly preferably a compound represented by one of the following formulas (5) to (18).

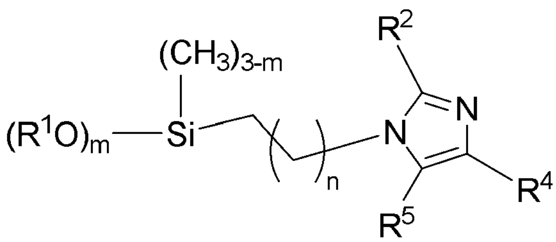

(5)

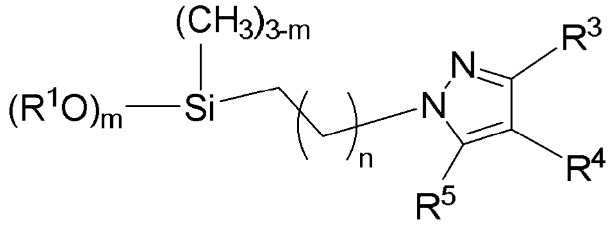
(6)

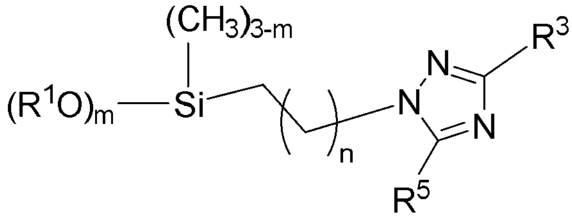
(7)

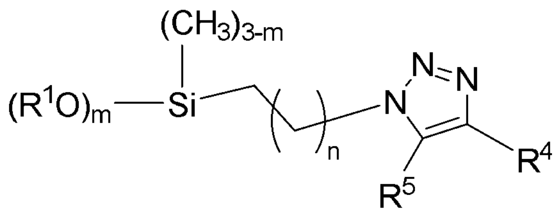
(8)

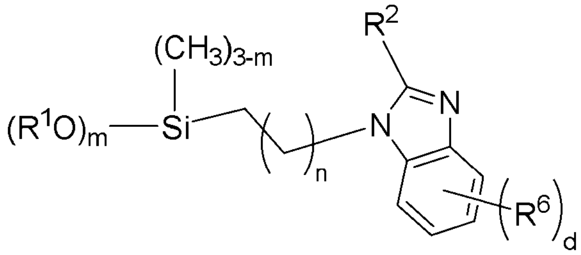
(9)

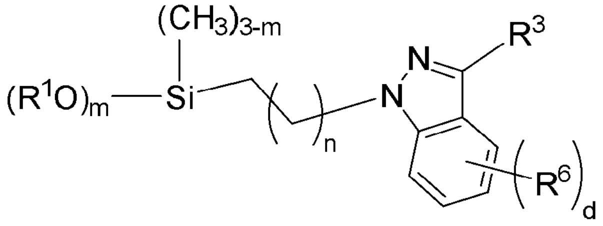
(10)

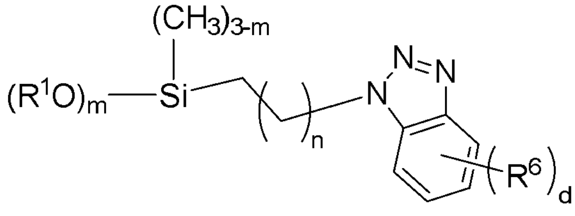
(11)

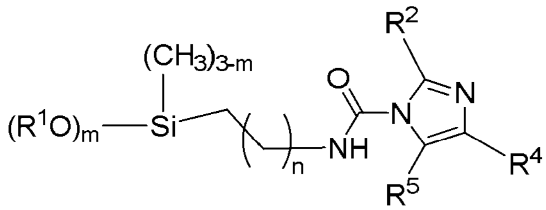
(12)

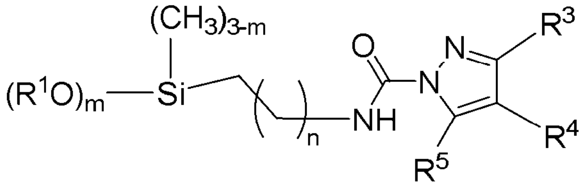

(13)

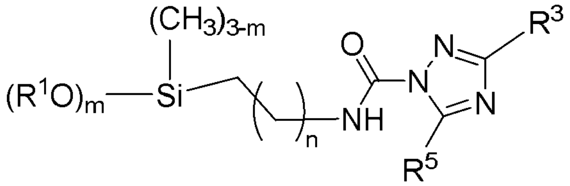

(14)

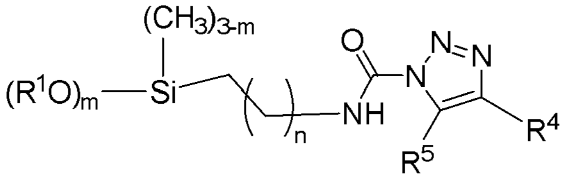

(15)

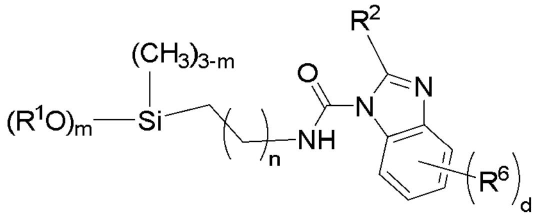

(16)

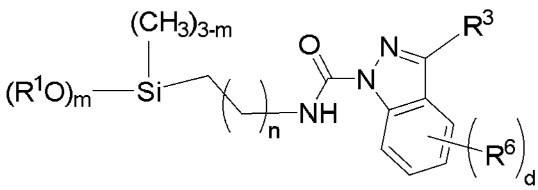

(17)

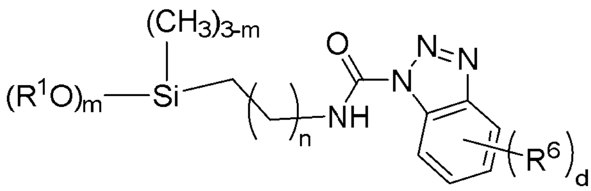

(18)

In formulas (5) to (18), $R^1$ to $R^5$, m and n are as defined above, $R^6$ represents, independently of each other, a hydrogen atom, an alkyl group, or a phenyl group, and d is an integer of 0 to 4, preferably 0.

In formulas (5) to (18), $R^2$ to $R^6$ are preferably a hydrogen atom, and preferably all of $R^2$ to $R^6$ are a hydrogen atom.

The amount of component (B) is 0.1 to 10 parts by mass, preferably 0.2 to 8 parts by mass, more preferably 0.3 to 6 parts by mass, relative to total 100 parts by mass of the thermosetting resin (A) and the optional curing agent. Component (B) produces good adhesion with metals when the amount of component (B) is within these ranges.

(C) Curing accelerator

The thermosetting resin composition of the present invention contains a curing accelerator (C). The curing accelerator is not particularly limited as long as the curing accelerator promotes reactions between components (A) or between component (A) and other components. Examples of the curing accelerator include imidazoles such as 2-methylimidazole, 2-ethyl-4-methylimidazole, 2-methyl-4-ethylimidazole, 2-phenylimidazole, and 2-methyl-4-methylimidazole; tertiary amines such as 1,8-diazabicyclo[5.4.0]undecene-7, triethylenediamine, and benzyldimethylamine; organophosphines such as triphenylphosphine, tributylphosphine, tetraphenylphosphonium-tetraphenylborate, and microencapsulated products thereof; compounds having a urea structure such as *N,N,N',N'*-tetramethylurea, *N'*-phenyl-*N,N*-dimethylurea, *N,N*-diethylurea, *N'*-[3-[[[(dimethylamino)carbonyl]amino]methyl]-3,5,5-trimethylcyclohexyl]-*N,N*-dimethylurea, and *N,N"*-(4-methyl-1,3-phenylene)bis(*N',N'*-dimethylurea) ; and organic peroxides such as dicumyl peroxide, 2,5-dimethyl-2,5-di(*tert*-butylperoxy)hexane, *tert*-butyl cumyl peroxide, di-tert-butyl peroxide, 1,1,3,3-tetramethylbutyl hydroperoxide, and cumene hydroperoxide. These may be used alone or in combination with two or more thereof.

The amount of component (C) is preferably 0.2 to 8.0 parts by mass, more preferably 0.4 to 6.0 parts by mass, relative to total 100 parts by mass of component (A) and the optional curing agent. As long as the amount of component (C) is within these ranges, the thermosetting resin reacts quickly, and a cured product forms easily.

(D) Inorganic filler

The thermosetting resin composition of the present invention contains an inorganic filler (D). The inorganic filler is added to reduce the thermal expansion coefficient and improve mechanical properties of the cured product of the thermosetting resin composition of the present invention. Examples of the inorganic filler include silicas such as spherical silica, fused silica, crystalline silica, and cristobalite; alumina, silicon nitride, aluminum nitride, boron nitride, titanium oxide, a glass fiber, and magnesium oxide. The average particle size and shape of these inorganic fillers may be selected according to their intended applications.

The top cut diameter of component (D) is preferably 5 to 120 μm, more preferably 10 to 75 μm, as determined by wet sieving. Herein, top cut diameter refers to the mesh opening of a sieve used to classify the prepared inorganic filler with wet sieving, and refers to a value such that the percentage of particles larger than the mesh opening in the volumetric particle size distribution is 2% by volume or less, as determined by laser diffraction.

The amount of component (D) is preferably 50 to 1,500 parts by mass, more preferably 150 to 1,200 parts by mass, relative to total 100 parts by mass of component (A) and the optional curing agent. The amount of the inorganic filler in the composition is preferably 30 to 97% by mass, more preferably 40 to 95% by mass, even more preferably 50 to 92% by mass, relative to 100% by mass of the total mass of the composition.

To increase the bond strength between the resin components and the inorganic filler, component (D) may be surface-treated beforehand with a coupling agent such as a silane coupling agent or a titanate coupling agent. Examples of such a coupling agent include epoxy group, amino group, mercapto group, vinyl group, styryl group, or methacryl group-containing silane coupling agents such as epoxy silanes such as 3-glycidoxypropyltrimethoxysilane, 3-glycidoxypropylmethyldiethoxysilane, 2-(3,4-epoxycyclohexyl)ethyltrimethoxysilane; aminosilanes such as *N*-2(aminoethyl)-3-aminopropyltrimethoxysilane, a reaction product of imidazole and 3-glycidoxypropyltrimethoxysilane, 3-aminopropyltrimethoxysilane, and *N*-phenyl-3-aminopropyltrimethoxysilane; mercaptosilanes such as 3-mercaptopropyltrimethoxysilane and 3-episulfidoxypropyltrimethoxysilane; vinylsilanes such as vinyltrimethoxysilane and vinyltriethoxysilane; styryl silanes such as *p*-styryltrimethoxysilane; and methacrylic silanes such as 3-methacryloxypropylmethyldimethoxysilane, 3-methacryloxypropyltrimethoxysilane, 3-methacryloxypropylmethyldiethoxysilane, and 3-methacryloxypropyltriethoxysilane. Particularly preferred is an amino group-containing silane coupling agent, in view of its increased strength. The amount of the coupling agent and the surface treatment method used in the aforementioned surface treatment are not particularly limited.

The thermosetting resin composition of the present invention may contain a silane coupling agent other than component (B). The aforementioned silane coupling agent performs the role of increasing the adhesion force between component (B) and the metal. The aforementioned silane coupling agent is not particularly limited, but is preferably epoxy silanes such as 3-glycidoxypropyltrimethoxysilane, 3-glycidoxypropylmethyldiethoxysilane, 2-(3,4-epoxycyclohexyl) ethyltrimethoxysilane; aminosilanes such as N-2(aminoethyl)-3-aminopropyltrimethoxysilane, a reaction product of imidazole and 3-glycidoxypropyltrimethoxysilane, 3-aminopropyltrimethoxysilane, and N-phenyl-3-aminopropyltrimethoxysilane; and mercaptosilanes such as 3-mercaptopropyltrimethoxysilane and 3-episulfidoxypropyltrimethoxysilane, particularly preferably 3-glycidoxypropyltrimethoxysilane, N-phenyl-3-aminopropyltrimethoxysilane, and 3-mercaptopropyltrimethoxysilane.

The amount of the aforementioned silane coupling agent other than component (B) is preferably 0.1 to 10 parts by mass, more preferably 0.2 to 8 parts by mass, more preferably 0.3 to 6 parts by mass, relative to total 100 parts by mass of component (A) and the optional curing agent.

Other additives

The thermosetting resin composition of the present invention may further contain other additives such as a flame retardant, an ion-trapping agent, a flexibility-imparting agent, a colorant, and a release agent, if necessary.

Examples of the flame retardant include a halogenated epoxy resin, a phosphazene compound, a silicone compound, zinc molybdate-supported talc, zinc molybdate-supported zinc oxide, aluminum hydroxide, aluminum hydroxide oxide, magnesium hydroxide, molybdenum oxide, and antimony trioxide. These flame retardants may be used alone or in combination with two or more thereof; however, preferred are a phosphazene compound, zinc molybdate-supported zinc oxide, molybdenum oxide, and aluminum hydroxide, in view of their environmental impact and ensuring fluidity.

Examples of the ion-trapping agent include a hydrotalcite compound, a bismuth compound, and a zirconium compound. These may be used alone or in combination with two or more thereof.

Examples of the flexibility-imparting agent include silicone compounds such as a silicone oil, a silicone resin, a silicone-modified epoxy resin, and a silicone-modified phenolic resin; and thermoplastic elastomers such as a styrene resin and an acrylic resin. These may be used alone or in combination with two or more thereof.

Examples of the colorant include carbon black, titanium black, and titanium oxide. These may be used alone or in combination with two or more thereof.

Examples of the release agent include waxes such as carnauba wax, rice wax, polyethylene, oxidized polyethylene, montanic acid, and ester compounds of montanic acid with a saturated alcohol, 2-(2-hydroxyethylamino)-ethanol, ethylene glycol, or glycerin; stearic acid, stearic acid ester, stearamide, ethylenebisstearamide, and a copolymer of ethylene and vinyl acetate. These may be used alone or in combination with two or more thereof.

The content of the other additives in the epoxy resin composition may be appropriately set within a range such that the function of each additive manifests well, such as a range of 0.1 parts by mass or more and 20 parts by mass or less, relative to total 100 parts by mass of component (A) and the optional curing agent.

The thermosetting resin composition of the present invention may further contain a laser direct structuring additive. When the thermosetting resin composition contains a laser direct structuring additive, the amount of the laser direct structuring additive may be, for example, 20 to 100 parts by mass or 30 to 80 parts by mass, relative to 100 parts by mass of the thermosetting resin (A). Further, the amount of the laser direct structuring additive may be less than 20 parts by mass or 10 parts by mass or less, relative to 100 parts by mass of the thermosetting resin (A). In a more preferred embodiment, the thermosetting resin composition of the present invention does not contain a laser direct structuring additive.

The laser direct structuring additive is added to the thermosetting resin, and the cured product of the thermosetting resin is activated with a laser or other active energy ray, thereby allowing a plating layer (metal layer) to be formed only on the irradiated parts. For example, the laser direct structuring additive is a metal oxide with a spinel structure of the average composition formula: $AB_2O_4$, wherein A is one, two, or more metallic elements selected from the group consisting of iron, copper, nickel, cobalt, zinc, magnesium, and manganese, and B is iron, chrome, or tungsten, with the proviso that A and B are not both iron. The laser direct structuring additive may be one that is not surface-treated.

Method for preparing thermosetting resin composition

For example, the thermosetting resin composition of the present invention is prepared as follows. That is, combined are the thermosetting resin (A), the silane coupling agent (B), the curing accelerator (C), the inorganic filler (D), and other materials, each in their prescribed amounts, followed by mixing the mixture with a mixer or other device until the mixture is sufficiently uniform, after which the mixture is melt-mixed with heated rolls, a kneader, an extruder, or the like, followed by cooling and solidification, and pulverization to an appropriate size. The composition thus obtained may be used as a molding material. The composition also may be tableted and used in tablet form.

Component (B) has excellent reactivity with the thermosetting resin (A), resulting in a risk of reaction during melt mixing. It is therefore preferred to melt-mix the materials other than component (B) beforehand at 100 to 130°C, followed by cooling and solidification, and pulverization to an appropriate size, after which component (B) is added to the mixture, followed by mixing the mixture with a mixer or other device until the mixture is sufficiently uniform, after which the mixture is melt-mixed at 70 to 100°C. Further, a prescribed amount of component (B) may be added to the materials other than component (B) when melt-mixing the materials other than component (B).

Applications of thermosetting resin composition

The present invention provides a semiconductor device that includes a cured product of the aforementioned thermosetting resin composition. In the present invention, "semiconductor device" includes both a semiconductor device itself, and a substrate with a semiconductor device. Specifically, the present invention provides a semiconductor apparatus in which a semiconductor device and a substrate are encapsulated with a cured product of the aforementioned thermosetting resin composition. The thermosetting resin composition of the present invention is particularly effective as an encapsulating resin of surface mounted semiconductor elements such as SOP, SON, QFP, QFN, and ball grid array type semiconductor elements. The encapsulation method of the semiconductor element with the thermosetting resin

composition of the present invention is not particularly limited, and a conventional molding technique may be used, such as transfer molding, injection molding, compression molding, or casting.

Cured product of thermosetting resin composition

Molding (curing) conditions of the thermosetting resin composition of the present invention are not particularly limited, and the molding (curing) is preferably carried out at 120 to 190°C for 90 to 300 seconds. The postcure is preferably carried out at 170 to 250°C for 2 to 16 hours. The cured product of the resin composition of the present invention has particularly excellent adhesion to nickel and nickel/palladium/gold. The resin composition of the present invention is preferred as an encapsulant of surface mounted packages.

**EXAMPLES**

The present invention will be explained below in further detail with reference to a series of Examples and Comparative Examples, but the present invention is in no way limited by the following Examples.

Each of the components used in the Examples and the Comparative Examples are listed below. In the following descriptions, the amounts refer to parts by mass.

(A) Thermosetting resin

- Epoxy resin 1: Orthocresol novolac-type epoxy resin: "Epiclon N665EXP-S" (epoxy equivalent: 202) manufactured by DIC
- Epoxy resin 2: Biphenyl aralkyl-type epoxy resin: "NC-3000" (epoxy equivalent: 273) manufactured by Nippon Kayaku Co., Ltd.
- Epoxy resin 3: Dicyclopentadiene-modified phenol-type epoxy resin: "HP-7200" (epoxy equivalent: 259) manufactured by DIC

(B) Silane coupling agent

- Silane coupling agent 1: Imidazole group-containing silane coupling agent represented by the following formula (5'), wherein $R^1$ is a methyl group, m = 3, and n = 2: Manufactured by Shin-Etsu Chemical Co., Ltd.

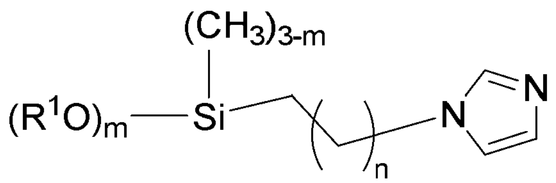

(5')

- Silane coupling agent 2: 1,2,4-Triazole group-containing silane coupling agent represented by the following formula (7'), wherein $R^1$ is a methyl group, m = 3, and n = 2: Manufactured by Shin-Etsu Chemical Co., Ltd.

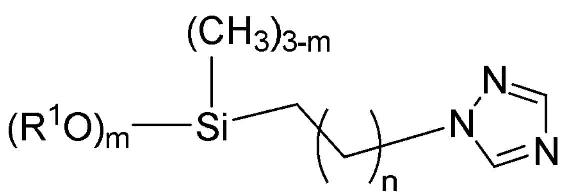

(7')

- Silane coupling agent 3: Benzimidazole group-containing silane coupling agent represented by the following formula (9'), wherein $R^1$ is a methyl group, m = 3, and n = 2: Manufactured by Shin-Etsu Chemical Co., Ltd.

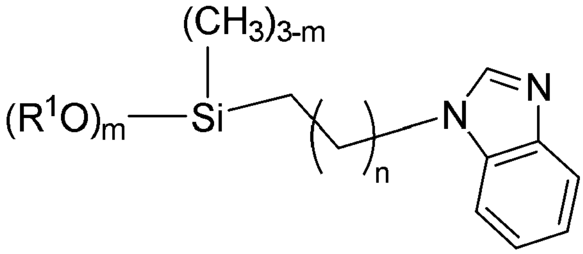

(9')

·Silane coupling agent 4: Benzimidazole group-containing silane coupling agent represented by the following formula (9'), wherein $R^1$ is a methyl group, m = 3, and n = 7: Manufactured by Shin-Etsu Chemical Co., Ltd.

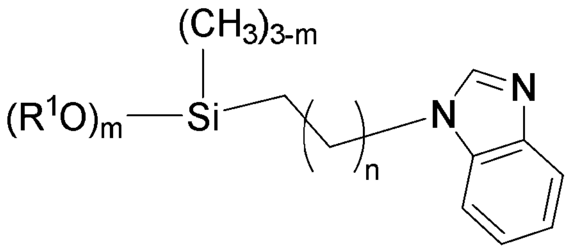

(9')

·Silane coupling agent 5: 1,2,3-Benzotriazole group-containing silane coupling agent represented by the following formula (11'), wherein $R^1$ is a methyl group, m = 3, and n = 2: Manufactured by Shin-Etsu Chemical Co., Ltd.

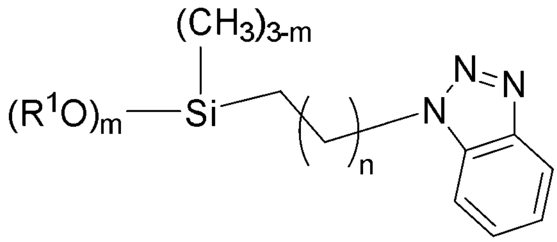

(11')

·Silane coupling agent 6: 1,2,3-Benzotriazole group-containing silane coupling agent represented by the following formula (18'), wherein $R^1$ is a methyl group, m = 3, and n = 2: Manufactured by Shin-Etsu Chemical Co., Ltd.

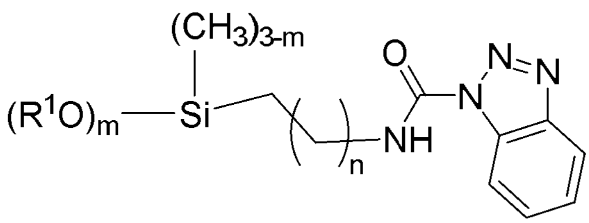

(18')

-Comparative Example silane coupling agent 7: 3-Glycidoxypropyltrimethoxysilane ("KBM-403" manufactured by Shin-Etsu Chemical Co., Ltd.)

(C) Curing accelerator

·Curing accelerator 1: 2-Phenylimidazole: "2PZ" by Shikoku Chemicals Corporation

(D) Inorganic filler

·Silica powder 1: Silica powder subjected to dry surface treatment with 0.3 parts by mass N-phenyl-3-aminopropyltrimethoxysilane (product name: KBM-573, manufactured by Shin-Etsu Chemical Co., Ltd.), relative to 100 parts by mass of molten spherical silica (average particle size of 13 μm, top cut diameter of 75 μm) manufactured by Tatsumori Ltd.

The following components were added when necessary.

(E) Curing agent

·Phenolic resin 1: Novolac-type phenolic resin: "TD-2093Y" (phenol equivalent: 110) manufactured by DIC
·Phenolic resin 2: Biphenyl aralkyl resin: "MEHC-7851SS" (phenol equivalent: 203) manufactured by Meiwa Plastic Industries, Ltd.

(F) Colorant

·Colorant 1: "Mitsubishi Carbon #3230B" manufactured by Mitsubishi Chemical Corporation

(G) Release agent

·Release agent 1: "TOWAX-131" manufactured by Toa Kasei Co., Ltd.

Examples 1 to 10 and Comparative Examples 1 to 3

Each of the components with the amounts (parts by mass) shown in Table 1 were melt-mixed, cooled, and pulverized to obtain resin compositions. Each composition was evaluated according to the following methods, and the results are shown in Table 1 or 2.

Adhesive strength to nickel after postcure

A truncated circular conic test piece from the composition having an upper surface with a diameter of 3 mm, a lower surface with a diameter of 3.568 mm, and a height of 3 mm, was molded on a copper substrate having a nickel-plated surface with the conditions of a molding temperature of 175°C, a molding pressure of 6.9 MPa, and a molding time of 120 seconds. The test piece thus obtained was postcured at 180°C for 4 hours, after which the shear adhesive strength was measured with a bond tester DAGE-SERIES-4000PXY, manufactured by Dage Corporation, at room temperature (25°C).

Adhesive strength to nickel after reflow resistance test

A truncated circular conic test piece from the composition having an upper surface with a diameter of 3 mm, a lower surface with a diameter of 3.568 mm, and a height of 3 mm, was molded on a copper substrate having a nickel-plated surface with the conditions of a molding temperature of 175°C, a molding pressure of 6.9 MPa, and a molding time of 120 seconds. The test piece thus obtained was postcured at 180°C for 4 hours, then stored under conditions of 85°C/85% RH for 168 hours, and then passed through reflow at 260°C three times. Then, the shear adhesive strength was measured with a bond tester DAGE-SERIES-4000PXY, manufactured by Dage Corporation, at room temperature (25°C). The reduction ratio of the adhesive strength was determined from the following calculation formula.

{(adhesive strength to nickel after postcure - adhesive strength to nickel after reflow) /adhesive strength to nickel after postcure}×100

Adhesive strength to nickel/palladium/gold (hereinafter, NiPdAu) after postcure

A truncated circular conic test piece having an upper surface with a diameter of 3 mm, a lower surface with a diameter of 3.568 mm, and a height of 3 mm was molded on a copper substrate having a NiPdAu plated surface, with the conditions of a molding temperature of 175°C, a molding pressure of 6.9 MPa, and a molding time of 120 seconds. The test

piece thus obtained was postcured at 180°C for 4 hours, after which the shear adhesive strength was measured with a bond tester DAGE-SERIES-4000PXY, manufactured by Dage Corporation, at room temperature (25°C).

Adhesive strength to NiPdAu after reflow resistance test

A truncated circular conic test piece having an upper surface with a diameter of 3 mm, a lower surface with a diameter of 3.568 mm, and a height of 3 mm was molded on a copper substrate having a NiPdAu plated surface with the conditions of a molding temperature of 175°C, a molding pressure of 6.9 MPa, and a molding time of 120 seconds. The test piece thus obtained was postcured at 180°C for 4 hours, then stored under conditions of 85°C/85% RH for 168 hours, and then passed through reflow at 260°C three times. Then, the shear adhesive strength was measured with a bond tester DAGE-SERIES-4000PXY, manufactured by Dage Corporation, at room temperature (25°C). The reduction ratio of the adhesive strength was determined from the following calculation formula.

{(adhesive strength to NiPdAu after postcure - adhesive strength to NiPdAu after reflow) /adhesive strength to NiPdAu after postcure}x100

[Table 1]

| Composition formulation, parts by mass | | Example | | | | | | |
|---|---|---|---|---|---|---|---|---|
| | | 1 | 2 | 3 | 4 | 5 | 6 | 7 |
| (A) | Epoxy resin 1 | 66 | | | | | | |
| | Epoxy resin 2 | | 59 | | | | | |
| | Epoxy resin 3 | | | 71 | 71 | 71 | 71 | 71 |
| (B) | Silane coupling agent 1 | 2 | 2 | 2 | | | | |
| | Silane coupling agent 2 | | | | 2 | | | |
| | Silane coupling agent 3 | | | | | 2 | | |
| | Silane coupling agent 4 | | | | | | 2 | |
| | Silane coupling agent 5 | | | | | | | 2 |
| | Silane coupling agent 6 | | | | | | | |
| | Comparative Silane coupling agent 7 | | | | | | | |
| (C) | Curing accelerator 1 | 2 | 2 | 2 | 2 | 2 | 2 | 2 |
| (D) | Silica Powder 1 | 630 | 630 | 630 | 630 | 630 | 630 | 630 |
| (E) | Phenolic resin 1 | 34 | | 29 | 29 | 29 | 29 | 29 |
| | Phenolic resin 2 | | 41 | | | | | |
| (F) | Coloring agent 1 | 1.5 | 1.5 | 1.5 | 1.5 | 1.5 | 1.5 | 1.5 |
| (G) | Release agent 1 | 2 | 2 | 2 | 2 | 2 | 2 | 2 |
| Evaluation | Adhesive strength to nickel after postcure, MPa | 9.0 | 9.2 | 10.0 | 9.5 | 8.2 | 8.0 | 7.8 |
| | Adhesive strength to nickel after reflow, MPa | 6.5 | 7.0 | 8.2 | 6.0 | 4.2 | 3.5 | 3.2 |
| | Reduction ratio of the adhesive strength to nickel, % | 28 | 24 | 18 | 37 | 49 | 56 | 59 |
| | Adhesive strength to NiPdAu after postcure, MPa | 9.1 | 9.4 | 10.0 | 9.8 | 7.9 | 8.1 | 8.0 |
| | Adhesive strength to NiPdAu after reflow, MPa | 6.2 | 7.2 | 8.3 | 6.2 | 3.4 | 3.2 | 3.0 |
| | Reduction ratio of the adhesive strength to NiPdAu, % | 32 | 23 | 17 | 37 | 57 | 60 | 63 |

[Table 2]

| Composition formulation, parts by mass | | Example | | | Comparative Example | | |
|---|---|---|---|---|---|---|---|
| | | 8 | 9 | 10 | 1 | 2 | 3 |
| (A) | Epoxy resin1 | | | | 66 | | |
| | Epoxy resin2 | | | | | 59 | |
| | Epoxy resin3 | 71 | 71 | 71 | | | 71 |
| (B) | Silane coupling agent 1 | | 4 | | | | |
| | Silane coupling agent 2 | | | 4 | | | |
| | Silane coupling agent 3 | | | | | | |
| | Silane coupling agent 4 | | | | | | |
| | Silane coupling agent 5 | | | | | | |
| | Silane coupling agent 6 | 2 | | | | | |
| | Comparative Silane coupling agent 7 | | | | 2 | 2 | 2 |
| (C) | Curing accelerator 1 | 2 | 2 | 2 | 2 | 2 | 2 |
| (D) | Silica Powder 1 | 630 | 630 | 630 | 630 | 630 | 630 |
| (E) | Phenolic resin 1 | 29 | 29 | 29 | 34 | | 29 |
| | Phenolic resin 2 | | | | | 41 | |
| (F) | Coloring agent 1 | 1.5 | 1.5 | 1.5 | 1.5 | 1.5 | 1.5 |
| (G) | Release agent1 | 2 | 2 | 2 | 2 | 2 | 2 |
| Evaluation | Adhesive strength to nickel after postcure, MPa | 7.5 | 11.0 | 10.2 | 6.8 | 7.0 | 7.3 |
| | Adhesive strength to nickel after reflow, MPa | 3.0 | 8.7 | 6.3 | 1.2 | 1.5 | 1.8 |
| | Reduction ratio of the adhesive strength to nickel, % | 60 | 21 | 38 | 82 | 79 | 75 |
| | Adhesive strength to NiPdAu after postcure, MPa | 7.8 | 10.8 | 10.1 | 7.1 | 7.2 | 7.5 |
| | Adhesive strength to NiPdAu after reflow, MPa | 2.9 | 8.5 | 6.5 | 1.0 | 1.2 | 1.8 |
| | Reduction ratio of the adhesive strength to NiPdAu, % | 63 | 21 | 36 | 86 | 83 | 76 |

As shown in Tables 1 and 2, the cured product of the resin composition of the present invention has particularly excellent adhesion to nickel and nickel/palladium/gold. Therefore, the resin composition of the present invention is preferred as an encapsulant of surface mounted packages.

## Claims

**1.** A thermosetting resin composition comprising

(A) a thermosetting resin;
(B) a silane coupling agent represented by the following formula (I):

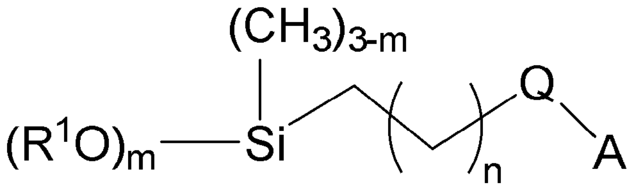

(I)

wherein, in formula (I), $R^1$ is, independently of each other, an alkyl group having 1 to 8 carbon atoms, m is an integer of 1 to 3, n is an integer of 0 to 10, Q is a single bond or an amide bond, -NHCO-, "A" is a nitrogen-containing heterocyclic group having at least two nitrogen atoms, wherein one of the nitrogen atoms is bonded to the carbon atom of $-(CH_2)_n-$ or of -NHCO-;

(C) a curing accelerator; and

(D) an inorganic filler.

**2.** The thermosetting resin composition according to claim 1, wherein the silane coupling agent (B) is one or more selected from compounds represented by the following formulas (1) to (4):

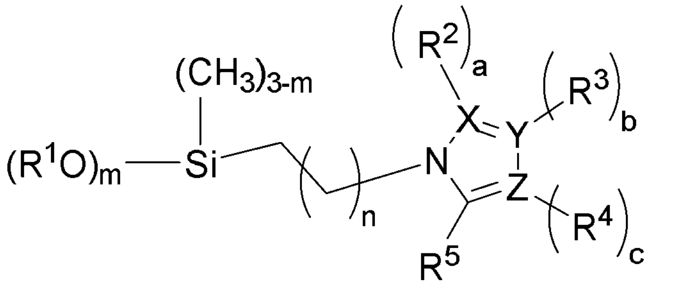

(1)

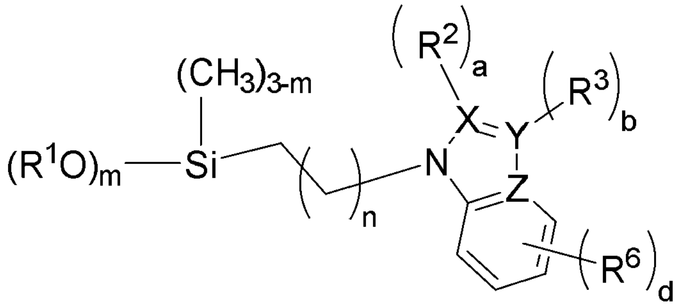

(2)

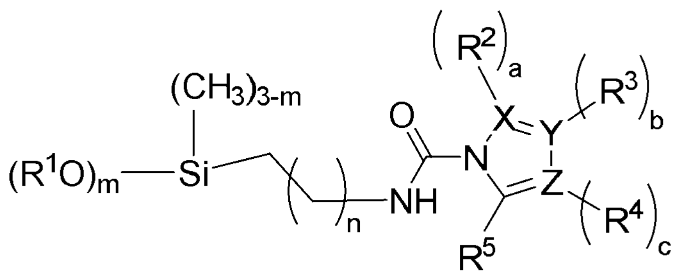

(3)

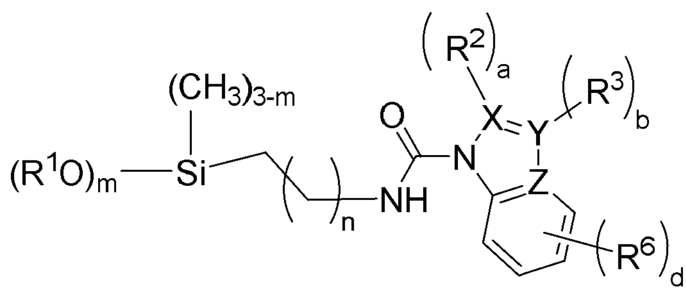

(4)

wherein, in formulas (1) to (4), $R^1$ is, independently of each other, an alkyl group having 1 to 8 carbon atoms, X, Y, and Z are, independently of each other, a carbon atom or a nitrogen atom, one or two among X, Y, and Z are a nitrogen atom, $R^2$ to $R^6$ are, independently of each other, a hydrogen atom, an alkyl group having 1 to 8 carbon atoms, or a phenyl group, m is an integer of 1 to 3, n is an integer of 0 to 10, a, b, and c are 0 or 1, wherein a is 1 when X is a carbon atom, a is 0 when X is a nitrogen atom, b is 1 when Y is a carbon atom, b is 0 when Y is a nitrogen atom, c is 1 when Z is a carbon atom, c is 0 when Z is a nitrogen atom, and d is an integer of 0 to 4.

**3.** The thermosetting resin composition according to claim 1, wherein the thermosetting resin composition optionally comprises an curing agent, and an amount of component (B) is 0.1 to 10 parts by mass, an amount of component (C) is 0.2 to 8 parts by mass, and an amount of component (D) is 50 to 1,500 parts by mass, relative to total 100 parts by mass of component (A) and the optional curing agent.

**4.** The thermosetting resin composition according to claim 1, wherein an amount of component (D) is 30 to 97% by mass, relative to a total mass of the thermosetting resin composition.

**5.** The thermosetting resin composition according to claim 1, wherein the thermosetting resin (A) is one or more selected from the group consisting of an epoxy resin, a phenolic resin, a maleimide resin, a bismaleimide resin, a citraconimide resin, a cyclic imide compound, a cyanate ester compound, a styrene resin, a cyclopentadiene compound and oligomers thereof, an oxetane resin, a (meth)acrylate resin, a terminal (meth)acrylic group-modified polyphenylene ether resin, an unsaturated polyester resin, and a diallyl phthalate resin.

**6.** The thermosetting resin composition according to claim 1, wherein the thermosetting resin (A) is an epoxy resin.

**7.** The thermosetting resin composition according to claim 6, further comprising a curing agent.

**8.** The thermosetting resin composition according to claim 6, wherein the epoxy resin is one or more selected from the group consisting of a phenol novolac-type epoxy resin, an orthocresol novolac-type epoxy resin, a biphenyl-type epoxy resin, a bisphenol-type epoxy resin, a triphenolmethane-type epoxy resin, an alkyl-modified triphenolmethane-type epoxy resin, a phenol aralkyl-type epoxy resin, a biphenyl aralkyl-type epoxy resin, and a dicyclopentadiene-modified phenol-type epoxy resin.

**9.** The thermosetting resin composition according to claim 7, wherein the curing agent is one or more selected from the group consisting of a phenol novolac resin, an orthocresol novolac resin, a triphenolmethane resin, an alkyl-modified triphenolmethane resin, a phenol aralkyl resin, a biphenyl aralkyl resin, and a dicyclopentadiene-modified phenolic resin.

**10.** The thermosetting resin composition according to claim 1, wherein Q in formula (I) is a single bond.

**11.** A semiconductor device having a cured product of the thermosetting resin composition according to any one of claims 1 to 10.

Europäisches Patentamt
European Patent Office
Office européen des brevets

# EUROPEAN SEARCH REPORT

Application Number
EP 25 20 9349

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 102 084 119 B1 (SAMSUNG SDI CO LTD [KR]) 3 March 2020 (2020-03-03)<br>* example comp. 3; tables 1,2 *<br>----- | 1-11 | INV.<br>C08K3/00<br>C08G59/00<br>C08K5/54 |
| X | BE 828 323 A (DYNAMIT NOBEL AG)<br>18 August 1975 (1975-08-18)<br>* example 8 *<br>----- | 1,2,4,5,10 | |
| X | JP H04 248830 A (TOSHIBA CHEM CORP)<br>4 September 1992 (1992-09-04)<br>* paragraphs [0005], [0013] *<br>* examples 1-3 *<br>* claims *<br>----- | 1,2,5-11 | |
| | | | TECHNICAL FIELDS SEARCHED (IPC) |
| | | | C08G |

The present search report has been drawn up for all claims

2

| Place of search | Date of completion of the search | Examiner |
|---|---|---|
| Munich | 20 March 2026 | Behm, Sonja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 20 9349

This annex lists the patent family members relating to the patent documents cited in the above-mentioned European search report. The members are as contained in the European Patent Office EDP file on
The European Patent Office is in no way liable for these particulars which are merely given for the purpose of information.

20-03-2026

| Patent document cited in search report | | Publication date | Patent family member(s) | | Publication date |
|---|---|---|---|---|---|
| KR 102084119 | B1 | 03-03-2020 | NONE | | |
| BE 828323 | A | 18-08-1975 | AT | 334402 B | 10-01-1976 |
| | | | BE | 828323 A | 18-08-1975 |
| | | | DE | 2420801 A1 | 13-11-1975 |
| JP H04248830 | A | 04-09-1992 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007063549 A